# EUROPEAN PATENT APPLICATION

(11) **EP 4 503 871 A1**
(43) Date of publication of application: **05.02.2025**
(21) Application number: 23189015.3
(22) Date of filing: 01.08.2023
(51) Int. Cl.: H05K 3/32

(54) **METHODS FOR CONNECTING TWO CONNECTION PARTNERS**

(71) Applicant: Infineon Technologies AG, 85579 Neubiberg (DE)
(72) Inventor: STROTMANN, Guido, 59609 Anröchte (DE); CILIOX, Alexander, 59519 Möhnesee (DE)
(74) Representative: Westphal, Mussgnug & Partner, Patentanwälte mbB

(57) **Abstract**

A method for connecting two connection partners comprises moving a second connection partner towards a first connection partner, and simultaneously heating a first section of the second connection partner, thereby softening the first section, and placing the second connection partner on the first connection partner such that its softened first section directly contacts the first connection partner.

## Description

### TECHNICAL FIELD

The instant disclosure relates to methods for connecting two connection partners, in particular for connecting two elements of a power semiconductor module arrangement with each other.

### BACKGROUND

Power semiconductor module arrangements often include at least one semiconductor substrate arranged in a housing. A semiconductor arrangement including a plurality of controllable semiconductor elements (e.g., two IGBTs in a half-bridge configuration) or non-controllable semiconductor elements (e.g., arrangements of diodes) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate.

The semiconductor substrate and the elements mounted thereon are usually electrically coupled to the outside of the housing by means of terminal elements. Such terminal elements are mechanically and electrically coupled to the substrate or to one or more of the elements mounted thereon with a first end, and from there extend through the housing to the outside of the housing. Terminal elements, as well as other elements of the power semiconductor module arrangement, are often coupled to the substrate or to other components of the power semiconductor module arrangement by means of soldering, sintering or welding techniques. The resulting connections should be stable, and the method that is used to form the connections should be swift, reliable, cost-effective and implementable in a space saving way.

There is a need for a method that allows to form reliable connections between two connection partners in a swift, reliable, cost-effective and space saving way.

### SUMMARY

A method for connecting two connection partners includes moving a second connection partner towards a first connection partner, and simultaneously heating a first section of the second connection partner, thereby softening the first section, and placing the second connection partner on the first connection partner such that its softened first section directly contacts the first connection partner.

Another method for connecting two connection partners includes moving a second connection partner towards a first connection partner, and placing the second connection partner on the first connection partner, wherein a section of the first connection partner to which the second connection partner is to be connected to is coupled to a first terminal of a power source, at least a first section of the second connection partner that is to be connected to the first connection partner is coupled to a second terminal of the power source, the first terminal of the power source is a positive terminal, and the second terminal of the power source is a negative terminal, or vice versa, and the power source is configured to provide a current that is greater than a threshold current or a voltage that is greater than a threshold voltage such that, when a distance between the first section of the second connection partner and the section of the first connection partner to which the second connection partner is to be connected decreases below a threshold distance, a flashover between the first section of the second connection partner and the section of the first connection partner to which the second connection partner is to be connected occurs, thereby softening or melting the first section of the second connection partner and the section of the first connection partner to which the second connection partner is to be connected.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2, including Figures 2A - 2C, schematically illustrates a method for forming a connection between two connection partners according to embodiments of the disclosure.
Figure 3, including Figures 3A - 3C, schematically illustrates a method for forming a connection between two connection partners according to further embodiments of the disclosure.
Figure 4, including Figures 4A - 4C, schematically illustrates a method for forming a connection between two connection partners according to even further embodiments of the disclosure.
Figure 5, including Figures 5A - 5C, schematically illustrates a method for forming a connection between two connection partners according to even further embodiments of the disclosure.
Figure 6, including Figures 6A - 6C, schematically illustrates a method for forming a connection between two connection partners according to even further embodiments of the disclosure.
Figure 7, including Figures 7A and 7B, schematically illustrates a method for forming a plurality of connections between a first connection partner and different second connection partners according to embodiments of the disclosure.
Figure 8, including Figures 8A - 8C, schematically illustrates different first and second connection partners according to embodiments of the disclosure.
Figure 9, including Figures 9A - 9F, schematically illustrates different terminal elements for a power semiconductor module arrangement according to embodiments of the disclosure.
Figure 10 schematically illustrates method for forming a connection between two connection partners according to embodiments of the disclosure.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

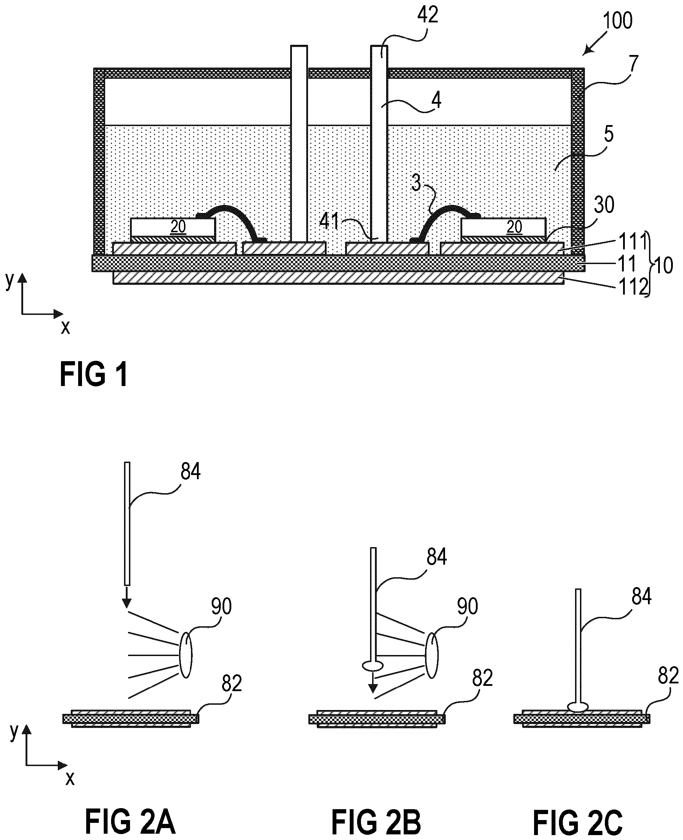

Referring to Figure 1, a cross-sectional view of a power semiconductor module arrangement 100 is illustrated. The power semiconductor module arrangement 100 includes a housing 7 and a semiconductor substrate 10. The semiconductor substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The semiconductor substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The semiconductor substrate 10 is arranged in a housing 7. In the example illustrated in Figure 1, the semiconductor substrate 10 forms a ground surface of the housing 7, while the housing 7 itself solely comprises sidewalls and a cover. This is, however, only an example. It is also possible that the housing 7 further comprises a ground surface and the semiconductor substrate 10 be arranged inside the housing 7. According to another example, the semiconductor substrate 10 may be mounted on a base plate (not illustrated). In some power semiconductor module arrangements 100, more than one semiconductor substrate 10 is arranged on a single base plate. The base plate may form a ground surface of the housing 7, for example. The top of the housing 7 can either be a separate cover or lid that can be removed from the sidewalls, or may be formed integrally with at least the sidewalls of the housing 7. In the latter case, the top and at least the sidewalls of the housing 7 may be formed as a single piece such that the top cannot be removed from the sidewalls without destroying the housing.

One or more semiconductor bodies 20 may be arranged on the semiconductor substrate 10. Each of the semiconductor bodies 20 arranged on the semiconductor substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable or non-controllable semiconductor element.

The one or more semiconductor bodies 20 may form a semiconductor arrangement on the semiconductor substrate 10. In Figure 1, only two semiconductor bodies 20 are exemplarily illustrated. The second metallization layer 112 of the semiconductor substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes four different sections. Different semiconductor bodies 20 may be mounted to the same or to different sections of the first metallization layer 111. Different sections of the first metallization layer may have no electrical connection or may be electrically connected to one or more other sections using, e.g., bonding wires 3. Electrical connections 3 may also include connection plates or conductor rails, for example, to name just a few examples. The one or more semiconductor bodies 20 may be electrically and mechanically connected to the semiconductor substrate 10 by an electrically conductive connection layer 30. Such an electrically conductive connection layer may be a solder layer, a layer of an electrically conductive adhesive, or a layer of a sintered metal powder, e.g., a sintered silver powder, for example.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of the terminal elements 4 protrudes out of the housing 7. The terminal elements 4 may be electrically contacted from the outside at their second end 42. The terminal elements 4 illustrated in Figure 1, however, are only examples. Terminal elements 4 may be implemented in any other way and may be arranged at any other position. For example, one or more terminal elements 4 may be arranged close to or adjacent to the sidewalls of the housing 7. Any other suitable implementation is possible. The terminal elements 4 may consist of or include a metal such as copper, aluminum, gold, silver, or any alloys thereof, for example. The terminal elements 4 may be electrically and mechanically connected to the semiconductor substrate 10 by an electrically conductive connection layer (not specifically illustrated for the terminal elements 4). Such an electrically conductive connection layer generally may be a solder layer, a layer of an electrically conductive adhesive, or a layer of a sintered metal powder, e.g., a sintered silver powder, for example. In other power semiconductor module arrangements, terminal elements 4, instead of directly on the substrate 10, may alternatively or additionally be arranged on semiconductor bodies 20 or on any other metallic components of the power semiconductor module arrangement 100. That is, terminal elements 4 do not necessarily have to be connected to the first metallization layer 111 of the substrate 10.

Conventional power semiconductor module arrangements 100 generally further include a casting compound 5. The casting compound 5 may consist of or include a silicone gel or may be a rigid molding compound, for example. The casting compound 5 may at least partly fill the interior of the housing 7, thereby covering the components and electrical connections that are arranged on the semiconductor substrate 10. The terminal elements 4 may be partly embedded in the casting compound 5. At least their second ends 42, however, are not covered by the casting compound 5 and protrude from the casting compound 5 through the housing 7, to the outside of the housing 7. The casting compound 5 is configured to protect the components and electrical connections inside the power semiconductor module 100, in particular inside the housing 7, from certain environmental conditions and mechanical damage.

Different methods are known for connecting different elements of the power semiconductor module arrangement 100 to each other. The terminal elements 4, for example, generally may be soldered or sintered to the first metallization layer 111 of the substrate 10 or to any other element of the power semiconductor module arrangement 100. When using such conventional methods, the terminal elements 4 are first placed on the substrate 10 (or on any other element of the power semiconductor module arrangement 100). A connecting (e.g., soldering or sintering) step follows. The tools that are used to form the connections often require a certain amount of space which may not always be available in a power semiconductor module arrangement 100 comprising a large number of components.

A method for connecting two connection partners 82, 84 according to embodiments of the disclosure comprises moving a second connection partner 84 towards a first connection partner 82, and simultaneously heating (at least) a first section of the second connection partner 84, thereby softening (at least) the first section. The method further comprises placing the second connection partner 84 on the first connection partner 82 such that its softened first section directly contacts the first connection partner 82. That is, instead of performing two subsequent steps (arranging the second connection partner 84 on the first connection partner and subsequently performing the connection step), the steps of moving the second connection partner 84 towards the first connection partner 82 and heating (softening) at least a first section of the second connection partner 84 are performed simultaneously. The softened first section of the second connection partner 84 may be placed on the first connection partner 82 by applying a certain amount of force. The softened first section 84, therefore, may be pressed on the first connection partner 82 and may be deformed (e.g., compressed) to a certain degree. The permanent connection between the first connection partner 82 and the second connection partner 84 forms when the first section of the second connection partner 84 subsequently cools down again. It is not necessary to actively cool the second connection partner 84. It is generally sufficient to stop applying heat to the first section of the second connection partner 84.

The first section of the second connection partner 84 may be heated up to a temperature that is high enough to soften the material of the first section of the second connection partner 84. Every material generally has a defined melting point. The first section of the second connection partner 84 may be heated to a temperature high enough to soften the material but below its melting point. In this way, material of the second connection partner 84 may be prevented from unintentionally dripping on the first connection partner 82.

It is generally also possible that the entire second connection partner 84 be heated, instead of only a first section. If, however, only a first section of the second connection partner 84 that is to be connected to the first connection partner 82 (e.g., only a first end 41 of a terminal element 4 is heated), the remaining parts of the second connection partner 84 may be handled without unintentionally deforming the second connection partner 84. Even further, it is usually more easy to solely heat a small section of a connection partner instead of the entire connection partner.

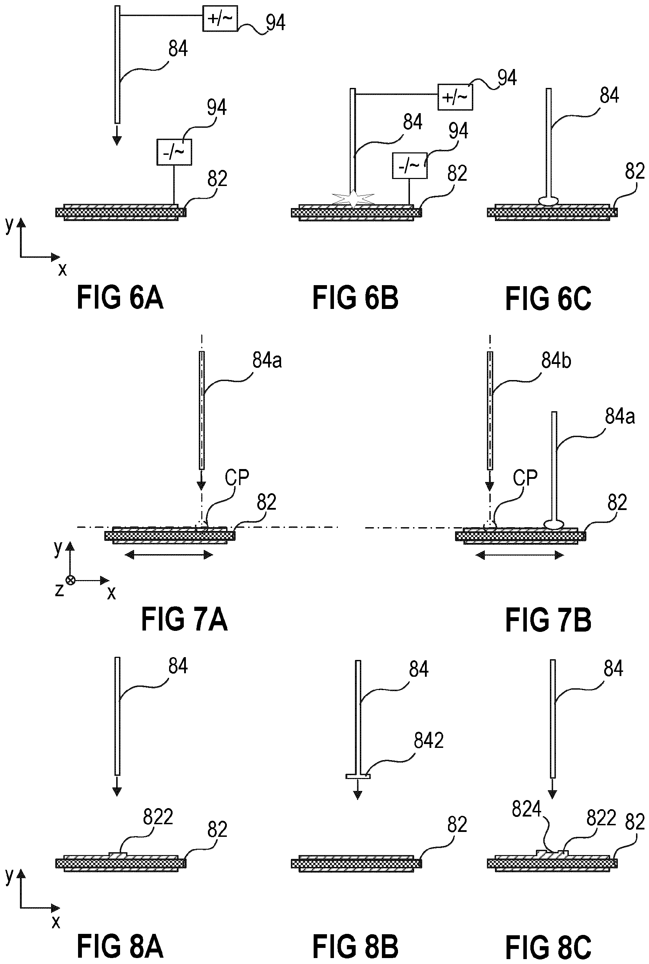

The first section of the second connection partner 84 may be heated in different ways, which will exemplarily described in the following. For example, the first section may be heated by means of a laser beam or an electron beam. Referring to Figures 2A to 2C, such a laser beam or electron beam may be static. A beam generation unit 90 may also be static in this example, as can be seen in Figures 2A and 2B. The beam generation unit 90 may be a laser unit or an electron gun, for example. That is, the beam is always directed in the same direction. When the second connection partner 84 is moved towards the first connection partner 82, it may be moved through the static beam (e.g., laser beam or electron beam). The first section, therefore, is softened while it is being moved towards the first connection partner 82. The beam generated by the beam generation unit 90 may have a comparably large diameter. If the second connection partner 84 is moved towards the first connection partner 82 at a defined speed, it will remain within the path of the beam for a longer time if its diameter is larger. A certain time may be required in order to soften the first section enough for forming a connection. When the second connection partner 84 reaches the first connection partner 82 (Figure 8C) it is soft enough such that it slightly deforms when it is placed on the first connection partner 82. The beam generation unit 90 may then be switched off, such that generating the beam is ceased and the first section is heated no longer and cools down again. In this way, a permanent connection between the two connection partners 82, 84 is formed.

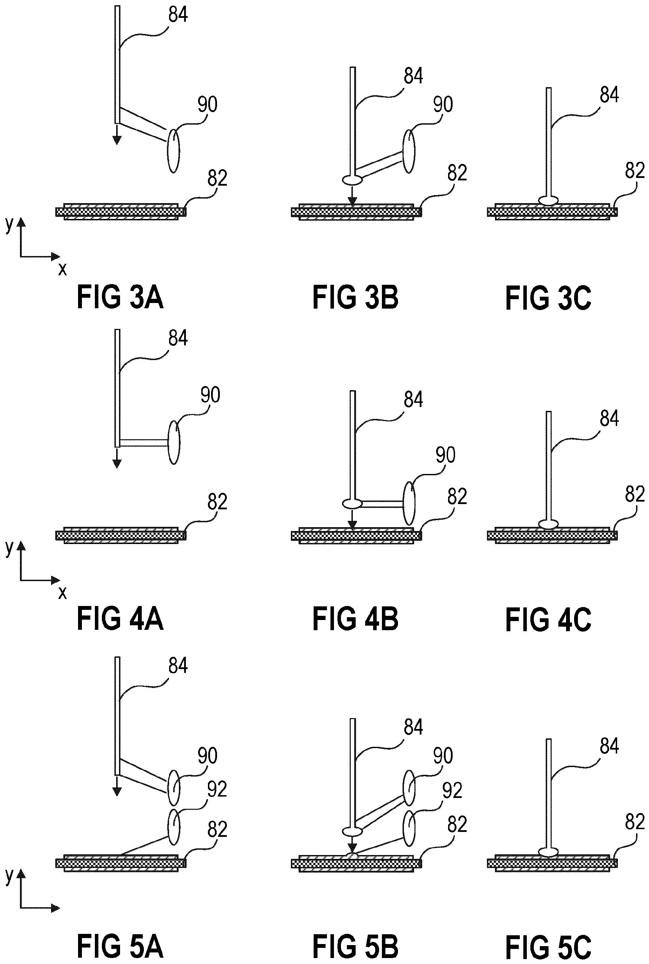

The beam being a static beam, however, is only an example. Referring to Figures 3A to 3C, another method according to further embodiments of the disclosure is schematically illustrated. In this example, the beam generation unit 90 also remains static, similar to what has been described with respect to Figure 2 above. The beam that is generated by the beam generation unit 90 in this example, however, is always focused on the first section of the second connection partner 84. That is, the beam can be moved such that it follows the movement of the first section. In an even further example, similar results may achieved by generating a beam that may be considered static with respect to the beam generation unit 90. The beam generation unit 90, however, may be moved, thereby following the movement of the first section. This is schematically illustrated in Figures 4A to 4C.

In the examples illustrated in Figures 2, 3 and 4, only the first section of the second connection partner 84 is heated, which is generally sufficient. It is, however, also possible to additionally heat a section of the first connection partner 82 to which the second connection partner 84 is to be connected. This is schematically illustrated in Figures 5A to 5C. A second laser beam or electron beam may be generated, for example, that is pointed on the section of the first connection partner 82 to which the second connection partner 84 is to be connected. The second beam may be generated by a second beam generation unit 92, for example, as is exemplarily illustrated in Figure 5. It is, however, also possible that one and the same beam generation unit is able to generate two separate beams, wherein one beam is directed towards the second connection partner 84, and the other beam is directed towards the first connection partner 82. The section of the first connection partner 82 to which the second connection partner 84 is to be connected may also be heated to a temperature below its melting point. That is, it may also be softened but not melted. This is schematically illustrated in Figure 5B. In this way, the strength of the resulting mechanical connection may be increased as compared to the embodiments of Figures 2, 3 and 4, for example. It may, however, not always be possible to reach each and every different section of a first connection partner 82 with a beam, e.g., due to limitations caused by a specific layout of the power semiconductor module arrangement 100.

Now referring to Figures 6A to 6C, a method for forming a connection between two connection partners 82, 84 according to even further embodiments of the disclosure is schematically illustrated. According to the method of Figure 6, the first connection partner 82 and the second connection partner are not heated by means of a beam (e.g., laser beam or electron beam). Instead, the connection between the two connection partners is formed by means of arc welding. The method comprises moving a second connection partner 84 towards a first connection partner 82, and placing the second connection partner 84 on the first connection partner 82. A section of the first connection partner 82 to which the second connection partner 84 is to be connected to is coupled to a first terminal of a power source 94, and at least a first section of the second connection partner 84 that is to be connected to the first connection partner 82 is coupled to a second terminal of the power source 94, wherein the first terminal of the power source 94 is a positive terminal, and the second terminal of the power source 94 is a negative terminal, or vice versa. The power source 94 is configured to provide a current that is greater than a threshold current or a voltage that is greater than a threshold voltage such that, when a distance between the first section of the second connection partner 84 and the section of the first connection partner 82 to which the second connection partner 84 is to be connected decreases below a threshold distance, a flashover (see Figure 6B) between the first section of the second connection partner 84 and the section of the first connection partner 82 to which the second connection partner 84 is to be connected occurs, thereby softening or melting the first section of the second connection partner 84 and the section of the first connection partner 82 to which the second connection partner 84 is to be connected.

According to one example, the power source 94 may be configured to provide a comparably high current and a comparably low voltage. Alternatively, the power source 94 may be configured to provide a comparably high voltage and a comparably low current. When the first connection partner 82 and the second connection partner 84 are close to each other (distance between first and second connection partner 82, 84 less than a threshold distance), a flashover occurs, thereby heating (and melting or at least softening) the respective sections of the first and second connection partner 82, 84. When the second connection partner 84 is placed on the first connection partner 82, the power source 94 may be switched off. The materials of the first connection partner 82 and the second connection partner 84 blend with each other, and the first and second connection partners 82, 84 subsequently cool down again, resulting in a permanent connection between the two connection partners 82, 84. The current or voltage that is to be provided by the power source 94 in order to melt the first and second connection partners 82, 84 generally depends on the material and size of the first and second connection partners 82, 84.

As has been described above, the first connection partner 82 and the second connection partner 84 may be elements of a power semiconductor module 100. For example, the first connection partner 82 may be a substrate 10 or a semiconductor body 20 (that is arranged on a substrate 10). The first connection partner 82 may also be any kind of element arranged in a power semiconductor module 100. The second connection partner 84 may be a terminal element 4 or a conductor rail or bus bar, for example.

In many applications, a plurality of second connection partners 84 is arranged on the same first connection partner 82. That is, a plurality of connection operations are performed successively on a first connection partner 82. Each of a plurality of different second connection partners 84 may be placed on the first connection partner 82 by the same handling machine. That is, a gripping tool, for example, may pick up a second connection partner 84, move it towards and place it on the first connection partner 82 until the connection has been formed. Then the gripping tool may pick up the next second connection partner 84 and perform another connecting process. During two different connection processes, the handling tool, for example, may only be moved in one direction of space. In the examples illustrated herein, this generally is a vertical direction y perpendicular to a top surface of the first connection partner 82, wherein the top surface of the first connection partner 82 is a surface to which the second connection partner 84 is to be mounted. During two connection processes, the first connection partner 82 may be moved in a horizontal plane (x, z) in order to align the position (connection point, CP) to which the next second connection partner 84 is to be connected with the gripping tool (with the next second connection partner). This is schematically illustrated in Figures 7A and 7B.

If only the first connection partner 82 is moved in a horizontal plane (x, z) for aligning the first and second connection partners 82, 84, a beam generation unit 90, 92 may also remain static at least horizontally (x, z). That is, the beam(s) may essentially be directed to one and the same position (vertically above the connection point CP) for each of a plurality of connection processes. In this way, only a single component (i.e. the first connection partner 82) needs to be moved horizontally between two connection processes. In this way, the cycle times may be significantly reduced.

Now referring to Figures 8A to 8C, the first section of the second connection partner 84 and/or the section of the first connection partner 82 to which the second connection partner 84 is to be connected may be optimized for the process. According to one example, as is schematically illustrated in Figure 8A, a respective section of the first connection partner 82 may have an increased thickness. If the first connection partner 82 is a substrate 10, for example, a thickness of the first metallization layer 111 may be locally increased. In this way, more material is provided at a connection point 822 for forming the connection. Instead of or in addition to locally increasing a thickness of the first connection partner 82, the first section of the second connection partner 84 may have an increased cross-sectional area. This may be achieved by providing a protrusion 842 at the first section of the second connection partner 84, for example, as is schematically illustrated in Figure 8B. In this way, also more material is provided for forming the connection between the two connection partners 82, 84. Now referring to Figure 8C, it is also possible to provide an indentation 824 in the area of increased thickness 822 of the first connection partner 82. The second connection partner 84 may be placed in this indentation 824. This may improve the blending of the materials of the first connection partner 82 and the second connection partner 84, resulting in a very reliable connection.

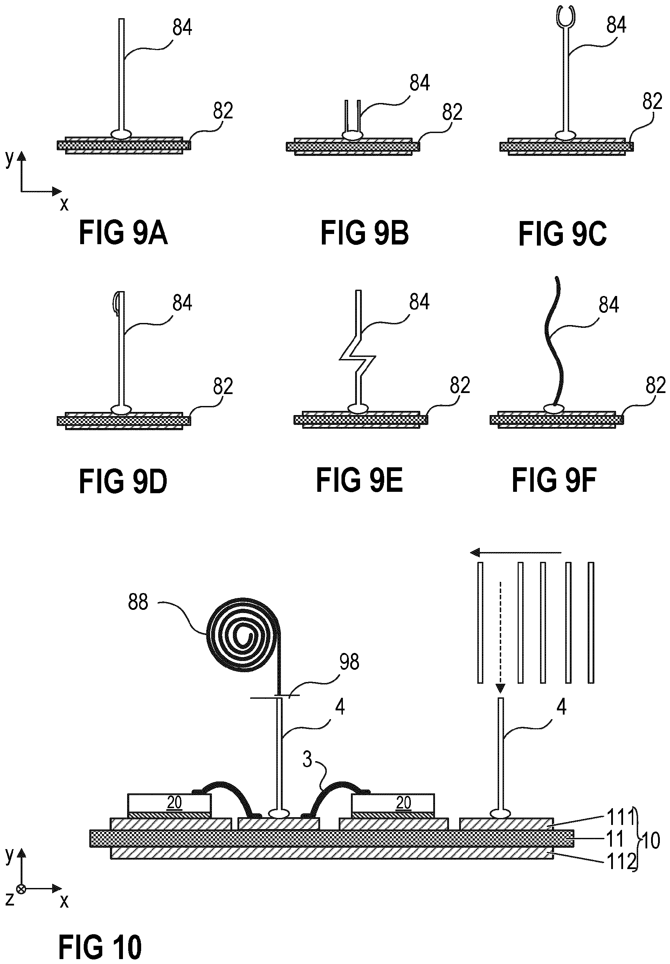

The first connection partner 82 and the second connection partner 84 generally may be any kind of element of a power semiconductor module 100, for example, that are to be connected to each other. As has been described above, the second connection partner 84 may be a conventional terminal element 4 that may be used to provide control signals to the power semiconductor module arrangement 100, for example. Terminal elements 4 are often implemented a simple pins, as is schematically illustrated in Figure 9A. As is illustrated in Figure 9B, the second connection partner 84 may also be or comprise a hollow sleeve, for example. The second connection partner 84 may also comprise a pin having a fork head at its second end, for example, as is schematically illustrated in Figure 9C. According to another example, the second connection partner 84 may be a pin having a press-fit connector at its second end, as is schematically illustrated in Figure 9D. Now referring to Figure 9E, the second connection partner 84 may also be a terminal element comprising any kind of mechanically compensating element. It is even possible, that the second connection partner 84 simply is or comprises a flexible wire, as is schematically illustrated in Figure 9F. Generally, the second connection partner 84 may be implemented in many different ways. The embodiments that are schematically illustrated in Figures 9A to 9F are merely examples.

Now referring to Figure 10, different ways of how a second connection partner 84 may be supplied are exemplarily illustrated. On the left side of Figure 10, a second connection partner 84 is provided from a continuous reel 88. The continuous reel 88 may be unrolled to a certain degree, moving a free end of the continuous reel 88 towards the first connection partner 82 (e.g., substrate 10 of a power semiconductor module 100). The second connection partner 84 (e.g., terminal element 4) may then be cut off from the continuous reel 88 by means of a cutting device 98. The connection between the second connection partner 84 and the first connection partner 82 may be formed by means of a method as has been described above. The continuous reel 88, according to one example, may remain in its position and the substrate 10 may be moved in a horizontal plane (x, z) before performing a next connection process.

As is schematically illustrated on the right side of Figure 10, according to another example, separate second connection partners 84 (e.g., terminal elements 4) may be provided by means of a kind of strap or depot containing a plurality of second connection partners 84. One second connection partner 84 may be moved from the strap or depot towards the first connection partner 82 and may be connected to the first connection partner 82 as has been described above. The strap or depot and the first connection partner 82 may then be realigned before moving a next one of the second connection partners 84 towards the first connection partner 82 and performing a further connection process. In this way, a plurality of second connection partners 84 may subsequently be connected to the same first connection partner 82 in a very efficient way.

The methods that have been described above result in very reliable connections between two connection partners 82, 84. With respect to the methods described with respect to Figures 2 to 5, the second connection partner 84, and optionally the first connection partner 82, are heated very homogeneously before the actual connection is formed. Due to the homogenous heating, there is generally no warping of the materials. When the softened second connection partner 84 is pressed on the (optionally also softened) first connection partner 82, the material of the second connection partner 84 will be compressed to a certain degree. This results in a certain enlargement of the cross-sectional area of the second connection partner 84 in the area where the connection is formed. The resulting connection, therefore, is very stable. The overall cycle time when arranging a plurality of second connection partners 84 on a first connection partner 82 may be significantly reduced with the methods described herein.

## Claims

1. A method for connecting two connection partners (82, 84) comprises:
moving a second connection partner (84) towards a first connection partner (82), and simultaneously heating a first section of the second connection partner (84), thereby softening the first section; and
placing the second connection partner (84) on the first connection partner (82) such that its softened first section directly contacts the first connection partner (82).

2. The method of claim 1, wherein at least the first section of the second connection partner (84) consists of a first material having a defined melting point, and wherein heating the first section comprises heating the first section to a temperature below its melting point.

3. The method of claim 1 or 2, wherein the first section of the second connection partner (84) is heated by moving the first section through a static laser beam or a static electron beam.

4. The method of claim 1 or 2, wherein the first section of the second connection partner (84) is heated by pointing a laser beam or an electron beam on the first section and moving the laser beam or electron beam together with the first section.

5. The method of any of the preceding claims, further comprising heating a section of the first connection partner (82) to which the second connection partner (84) is to be connected.

6. The method of claim 5, wherein heating a section of the first connection partner (82) comprises heating the section by means of a laser beam or an electron beam.

7. The method of any of the preceding claims, wherein
the first connection partner (82) is a substrate (10) for a semiconductor module (100) or a semiconductor body (20) arranged on a substrate (10); and
the second connection partner (84) is a terminal element (4), conductor rail or bus bar for a semiconductor module (100).

8. The method of any of the preceding claims, wherein moving a second connection partner (84) towards a first connection partner (82) comprises a movement of the second connection partner (84) in only one direction of space.

9. The method of any of claims 3 to 8, wherein the laser beam or electron beam is generated by means of a beam generation unit (90), and wherein the method further comprises switching off the beam generation unit (90) and cease generating the laser beam or electron beam after placing the second connection partner (84) on the first connection partner (82).

10. A method for connecting two connection partners (82, 84) comprises:
moving a second connection partner (84) towards a first connection partner (82); and
placing the second connection partner (84) on the first connection partner (82), wherein
a section of the first connection partner (82) to which the second connection partner (84) is to be connected to is coupled to a first terminal of a power source (94),
at least a first section of the second connection partner (84) that is to be connected to the first connection partner (82) is coupled to a second terminal of the power source (94),
the first terminal of the power source (94) is a positive terminal, and the second terminal of the power source (94) is a negative terminal, or vice versa, and
the power source (94) is configured to provide a current that is greater than a threshold current or a voltage that is greater than a threshold voltage such that, when a distance between the first section of the second connection partner (84) and the section of the first connection partner (82) to which the second connection partner (84) is to be connected decreases below a threshold distance, a flashover between the first section of the second connection partner (84) and the section of the first connection partner (82) to which the second connection partner (84) is to be connected occurs, thereby softening or melting the first section of the second connection partner (84) and the section of the first connection partner (82) to which the second connection partner (84) is to be connected.

11. The method of claim 10, wherein the first connection partner (82) and the second connection partner (84) are elements of a power semiconductor module (100).

12. The method of claim 11, wherein
the first connection partner (82) is a substrate (10) for a semiconductor module (100) or a semiconductor body (20) arranged on a substrate (10); and
the second connection partner (84) is a terminal element (4), conductor rail or bus bar for a semiconductor module (100).

13. The method of any of claims 10 to 12, further comprising switching off the power source (94) after placing the second connection partner (84) on the first connection partner (82).

## Amended claims

### Amended claims in accordance with Rule 137(2) EPC.

1. A method for connecting two connection partners (82, 84) comprises:
moving a second connection partner (84) towards a first connection partner (82), and simultaneously heating a first section of the second connection partner (84), thereby softening the first section; and
placing the second connection partner (84) on the first connection partner (82) such that its softened first section directly contacts the first connection partner (82), wherein
the first connection partner (82) is a substrate (10) for a semiconductor module (100) or a semiconductor body (20) arranged on a substrate (10); and
the second connection partner (84) is a terminal element (4), conductor rail or bus bar for a semiconductor module (100).

2. The method of claim 1, wherein at least the first section of the second connection partner (84) consists of a first material having a defined melting point, and wherein heating the first section comprises heating the first section to a temperature below its melting point.

3. The method of claim 1 or 2, wherein the first section of the second connection partner (84) is heated by moving the first section through a static laser beam or a static electron beam.

4. The method of claim 1 or 2, wherein the first section of the second connection partner (84) is heated by pointing a laser beam or an electron beam on the first section and moving the laser beam or electron beam together with the first section.

5. The method of any of the preceding claims, further comprising heating a section of the first connection partner (82) to which the second connection partner (84) is to be connected.

6. The method of claim 5, wherein heating a section of the first connection partner (82) comprises heating the section by means of a laser beam or an electron beam.

7. The method of any of the preceding claims, wherein moving a second connection partner (84) towards a first connection partner (82) comprises a movement of the second connection partner (84) in only one direction of space.

8. The method of any of claims 3 to 7, wherein the laser beam or electron beam is generated by means of a beam generation unit (90), and wherein the method further comprises switching off the beam generation unit (90) and cease generating the laser beam or electron beam after placing the second connection partner (84) on the first connection partner (82).
